# DEMANDE DE BREVET EUROPEEN

(11) **EP 0 887 823 A1**
(43) Date de publication de la demande: **30.12.1998**
(21) Numéro de dépôt: 98401569.3
(22) Date de dépôt: 25.06.1998
(51) Int. Cl.: H01H 33/56

(54) **Dispositif d'absorption d'humidité pour appareil électrique a gaz diélectrique**

(30) Priorité: 26.06.1997 FR 9708016
(71) Demandeur: GEC ALSTHOM T ET D, 75116 Paris (FR)
(72) Inventeur: Ledru, Roger, 38230 Tignieu (FR); Tolossi, Antoine, 01700 Beynost (FR)
(74) Mandataire: Gosse, Michel

(57) **Abrégé**

Le dispositif d'absorption d'humidité à tamis moléculaire pour appareil électrique à gaz diélectrique comprend un boîtier (4) dans lequel est placé le tamis moléculaire (5). Ce boîtier est fermé par une plaque (7) munie d'une valve (8) par laquelle on fait le vide à l'intérieur du boîtier. Cette plaque est tenue en place sur un épaulement (6) du boîtier par le jeu d'une différence de pression entre l'intérieur et l'extérieur du boîtier après avoir fait le vide à l'intérieur du boîtier. Un joint (9) est placé entre la plaque et l'épaulement pour assurer l'étanchéité du volume intérieur du boîtier. Ce dispositif peut être stocké indépendamment de l'appareil. Quand il est monté sur l'appareil, la mise sous vide de l'enveloppe de l'appareil provoque la séparation de la plaque et du boîtier et donc un contact entre le tamis moléculaire et le volume intérieur de l'enveloppe à traiter.

## Description

L'invention concerne les appareils électriques à gaz diélectrique du type blindés sous enveloppe métallique ou à enveloppe en porcelaine, et plus particulièrement un dispositif d'absorption d'humidité à tamis moléculaire pour de tels appareils.

Dans un appareil électrique blindé sous enveloppe métallique par exemple, comme un disjoncteur, on utilise comme tamis moléculaire pour absorber l'humidité et les produits de décomposition formés lors des coupures, un aluminosilicate sous forme de petits cristaux où en bâtonnets. Ce tamis moléculaire, avide d'eau, est placé dans un boîtier métallique tubulaire qui est bridé sur le col d'un orifice prévu dans l'enveloppe métallique de l'appareil. Durant l'expédition sur site ou le stockage avant mise en service d'un tel appareil, on met en place une plaque d'obturation entre le tube contenant le tamis moléculaire et l'enveloppe pour éviter un contact entre le tamis moléculaire placé dans le tube et l'air contenu dans l'enveloppe. A la mise en service de l'appareil électrique, la plaque d'obturation est retirée pour mettre en communication le volume intérieur du tube contenant le tamis moléculaire et le volume intérieur de l'enveloppe à traiter, puis on fait le vide dans l'enveloppe de l'appareil avant de la remplir de gaz diélectrique. Le retrait de cette plaque d'obturation au moment de la mise en service de l'appareil nécessite donc une opération de démontage de la bride puis une opération de montage de la bride qui tient le tube sur l'enveloppe.

Le but de l'invention est de proposer un dispositif d'absorption d'humidité à tamis moléculaire conçu de telle façon à éviter ces opérations de démontage et de montage avant la mise en service d'un tel appareil électrique.

A cet effet, l'invention a pour objet un dispositif d'absorption d'humidité à tamis moléculaire pour appareil électrique à gaz diélectrique, comprenant un boîtier dans lequel est placé le tamis moléculaire, caractérisé en ce que le boîtier est fermé par une plaque munie d'une valve par laquelle on fait le vide à l'intérieur du boîtier, en ce que cette plaque est tenue en place sur un épaulement du boîtier par le jeu d'une différence de pression entre l'intérieur et l'extérieur du boîtier après avoir fait le vide à l'intérieur du boîtier, et en ce qu'au moins un premier joint est placé entre la plaque et l'épaulement pour réaliser l'étanchéité du volume intérieur du boîtier.

Un tel agencement permet de stocker le dispositif d'absorption d'humidité indépendamment de l'appareil à traiter puisque le produit d'absorption d'humidité n'est pas mis en contact avec de l'air à l'intérieur du boîtier.

Quand ce dispositif est monté sur un appareil électrique qui n'est pas encore mis en service, l'ensemble peut encore être stocké sans risque de dégradation du produit d'absorption d'humidité. La mise en contact de ce produit avec le volume intérieur de l'enveloppe de l'appareil se fait sans démontage au moment où on fait le vide dans l'enveloppe, la plaque se séparant du boîtier par le jeu de la résultante des forces de pression exercées sur cette plaque. En outre, en se séparant du boîtier, le bruit engendré par la chute de la plaque dans le boîtier permet de contrôler facilement la mise en contact du produit avec le volume intérieur de l'enveloppe à traiter.

D'autres caractéristiques et avantages apparaîtront encore mieux à la lecture de la description qui suit d'exemples de réalisation de l'invention illustrés sur les dessins.

La figure 1 montre de façon très schématique en coupe axiale un premier exemple de réalisation d'un dispositif d'absorption d'humidité selon l'invention.

La figure 2 montre de façon très schématique en coupe axiale un second exemple de réalisation d'un dispositif d'absorption d'humidité selon l'invention.

La figure 3 montre de façon très schématique en coupe axiale un troisième exemple de réalisation d'un dispositif d'absorption d'humidité selon l'invention.

Le dispositif d'absorption d'humidité à tamis moléculaire selon l'invention est destiné à tout appareil électrique fonctionnant avec un gaz diélectrique sous pression dans une enveloppe étanche (liaison blindée, sectionneur, disjoncteurs, jeu de barres, etc...).

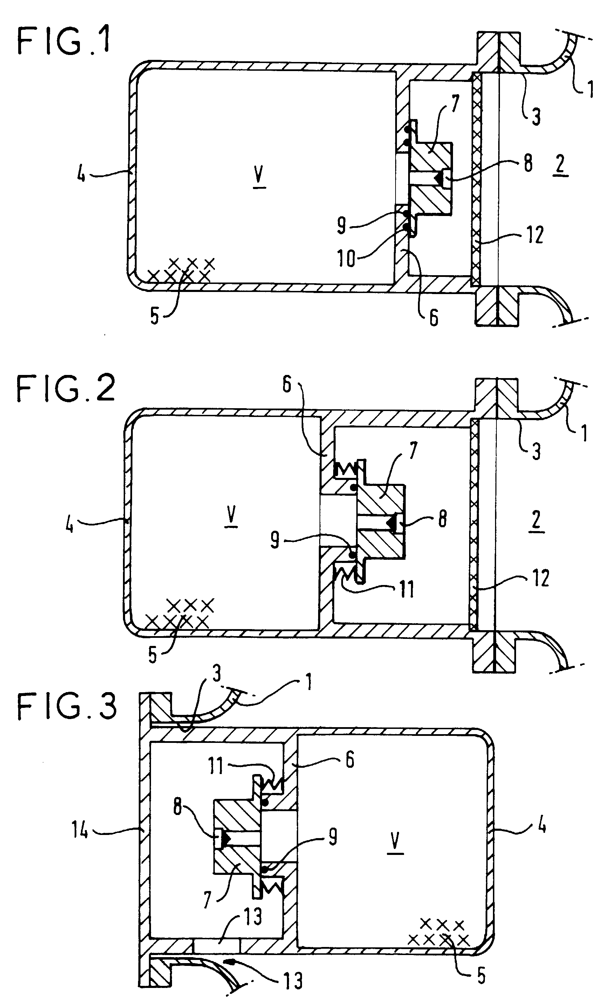

les figures montrent de façon partielle une enveloppe étanche 1 d'un tel appareil électrique. Elle présente un orifice 2 avec un col 3 sur lequel vient se brider le dispositif d'absorption d'humidité selon l'invention. Dans l'exemple de réalisation des figures 1 et 2, le dispositif d'absorption est fixé à l'extérieur de l'enveloppe d'un appareil électrique du type blindé. Le dispositif d'absorption d'humidité de la figure 3 est monté à l'intérieur d'une enveloppe métallique définissant une chambre de coupure d'un disjoncteur par exemple.

Comme visible sur la figure 1, le dispositif d'absorption d'humidité comprend un boîtier, ici un tube métallique 4, dont l'ouverture est bridée sur le col de l'orifice de l'enveloppe.

Le tamis moléculaire 5 est placé dans le fond du tube 4. Un épaulement 6 qui s'étend radialement à l'intérieur du tube 4 sert de support à une plaque 7 qui vient fermer le volume V dans lequel est placé le tamis moléculaire. La plaque 7 est munie d'une valve 8 qui sert à faire le vide à l'intérieur de ce volume de sorte à préserver intact le tamis moléculaire ainsi conditionné. L'étanchéité de ce volume est assuré par un joint 9 placé entre la plaque et l'épaulement. Quand on a fait le vide à l'intérieur de ce volume, la plaque tient en place par le jeu de la différence de pression entre ce volume et le volume extérieur du boîtier.

Au moment où on fait le vide à l'intérieur de l'enveloppe qui communique par son orifice 2 avec la plaque 7, cette dernière n'est plus tenue par le jeu des pressions et se sépare du boîtier par exemple par gravité. Sa chute dans le boîtier produit un bruit qui permet de contrôler la mise en communication du volume V dans lequel est placé le tamis moléculaire et du volume intérieur de l'enveloppe et donc la mise en contact de ce produit avec le volume à traiter de l'appareil. Ce bruit peut aussi être provoqué en secouant l'appareil.

Pour assurer une séparation encore plus efficace de la plaque et de l'épaulement (notamment si le joint 9 est collé entre la plaque et l'épaulement), on peut prévoir un second joint 10 qui est disposé autour du premier joint entre la plaque et l'épaulement. A la mise sous vide de l'enveloppe, la résultante des forces de pression agissant sur les deux joints fait que la plaque est décollée de l'épaulement.

On peut encore améliorer cette séparation par la présence d'un ressort il qui est comprimé pour agir entre le boîtier et la plaque comme montré sur les figures 2 et 3. La plaque est ainsi éjectée du boîtier à la mise sous vide de l'enveloppe à traiter quelque soit sa position par rapport à la verticale.

Une grille de protection 12 disposée au niveau de l'orifice 2 de l'enveloppe empêche la plaque de pénétrer dans l'enveloppe quand elle est séparée du boîtier.

Sur les figures 1 et 2, on voit que le boîtier est monté sur l'enveloppe à traiter de telle façon que la plaque avec la valve soit placée du côté de l'enveloppe pour des raisons de protection.

Figure 3, le boîtier 4 est monté dans le volume intérieur de l'enveloppe. Dans ce cas, une ouverture 13 est prévue dans la paroi du boîtier pour faire communiquer le volume de l'enveloppe avec la plaque et pour atteindre la valve afin de réaliser le vide dans le boîtier. Dans cette configuration, la grille n'est pas nécessaire et est remplacée par un flasque 14 qui est bridé sur le col de l'orifice de l'enveloppe.

## Revendications

1. Un dispositif d'absorption d'humidité à tamis moléculaire pour appareil électrique à gaz diélectrique, comprenant un boîtier (4) dans lequel est placé le tamis moléculaire (5), caractérisé en ce le boîtier est fermé par une plaque (7) munie d'une valve (8) par laquelle on fait le vide à l'intérieur du boîtier, en ce que cette plaque (7) est tenue en place sur un épaulement (6) du boîtier par le jeu d'une différence de pression entre l'intérieur et l'extérieur du boîtier après avoir fait le vide à l'intérieur du boîtier, et en ce qu'au moins un premier joint (9) est placé entre la plaque et l'épaulement pour réaliser l'étanchéité du volume intérieur (V) du boîtier.

2. Le dispositif selon la revendication 1, dans lequel un second joint (10) est placé autour du premier joint entre l'épaulement et la plaque.

3. Le dispositif selon l'une des revendications 1 ou 2, dans lequel un ressort (11) est disposé pour agir entre la plaque et le boîtier.

4. Un appareillage électrique comprenant une enveloppe (1) sur laquelle est fixé un dispositif selon l'une des revendications 1 ou 3 à l'endroit d'un orifice (2) dans l'enveloppe, une grille (12) étant en outre prévue au niveau de cet orifice pour empêcher la plaque de pénétrer à l'intérieur de l'enveloppe quand elle est séparée du boîtier.
